# FASCICULE DE BREVET EUROPEEN

(11) **EP 3 319 919 B1**
(45) Date de publication et mention de la délivrance du brevet: **16.06.2021**
(21) Numéro de dépôt: 16750913.2
(22) Date de dépôt: 30.06.2016
(51) Int. Cl.: C03C 17/36

(54) **SUBSTRAT MUNI D'UN EMPILEMENT A PROPRIETES THERMIQUES**
SUBSTRAT MIT EINEM STAPEL MIT WÄRMEEIGENSCHAFTEN
SUBSTRATE PROVIDED WITH A STACK HAVING THERMAL PROPERTIES

(30) Priorité: 08.07.2015 FR 1556476
(43) Date de publication de la demande: 16.05.2018
(73) Titulaire: SAINT-GOBAIN GLASS FRANCE, 92400 Courbevoie (FR)
(72) Inventeur: LORENZZI, Jean Carlos, 75011 Paris (FR); KAUFFMANN, Thierry, 75019 Paris (FR)
(74) Mandataire: Saint-Gobain Recherche
(86) Numéro de dépôt international: PCT/FR2016/051645
(87) Numéro de publication internationale: WO 2017/006027

(56) Documents cités:
- WO-A1-2013/104438
- WO-A1-2014/177798
- US-A1- 2007 116 967

## Description

L'invention concerne un matériau, tel qu'un vitrage, comprenant un substrat transparent revêtu d'un empilement de couches minces comprenant plusieurs couches fonctionnelles pouvant agir sur le rayonnement solaire et/ou le rayonnement infrarouge. L'invention concerne également les vitrages comprenant ces matériaux ainsi que l'utilisation de tels matériaux pour fabriquer des vitrages d'isolation thermique et/ou de protection solaire.

Ces vitrages peuvent être destinés aussi bien à équiper les bâtiments que les véhicules, en vue notamment de diminuer l'effort de climatisation et/ou d'empêcher une surchauffe excessive, vitrages dits « de contrôle solaire » et/ou diminuer la quantité d'énergie dissipée vers l'extérieur, vitrages dits « bas émissifs » entraînée par l'importance toujours croissante des surfaces vitrées dans les bâtiments et les habitacles de véhicules.

Selon les climats des pays où sont installés ces vitrages, les performances en termes de transmission lumineuse et de facteur solaire recherchées peuvent varier dans une certaine gamme. La transmission lumineuse doit être suffisamment faible pour supprimer l'éblouissement et suffisamment élevée pour que la diminution de la quantité de lumière pénétrant à l'intérieur de l'espace délimité par ledit vitrage ne rende pas obligatoire l'utilisation de la lumière artificielle. Par exemple, dans les pays où les niveaux d'ensoleillement sont élevés, il existe une demande forte de vitrage présentant une transmission lumineuse de l'ordre de 40 % et des valeurs de facteur solaire suffisamment basses.

Des vitrages comprenant des substrats transparents revêtus d'un empilement de couches minces comprenant trois couches fonctionnelles métalliques, chacune disposée entre deux revêtements diélectriques ont été proposés afin d'améliorer la protection solaire tout en conservant une transmission lumineuse suffisante. Ces empilements sont généralement obtenus par une succession de dépôts effectués par pulvérisation cathodique éventuellement assistée par champ magnétique. Ces vitrages sont qualifiés de sélectifs car ils permettent :
- de diminuer la quantité d'énergie solaire pénétrant à l'intérieur des bâtiments en présentant un faible facteur solaire (FS ou g),
- de garantir une transmission lumineuse suffisante,
- de présenter une faible émissivité pour réduire la déperdition de chaleur par le rayonnement infrarouge de grande longueur d'onde.

Selon l'invention, on entend :
- facteur solaire « g », le rapport en pourcentage entre l'énergie totale entrant dans le local à travers le vitrage et l'énergie solaire incidente,
- sélectivité « s », le rapport entre la transmission lumineuse et le facteur solaire TL/g.

Les matériaux de l'art antérieur à base d'empilement comprenant trois couches fonctionnelle les plus sélectifs permettent d'obtenir des valeurs de facteur solaire pouvant aller jusqu'à 22 %. Cependant, cette valeur est toujours trop élevée pour certains pays, où l'on recherche des valeurs de facteur solaire inférieur à 20%.

WO 2014/177798 A1, WO 2013/104438 A1 et US 2007/0116967 A1 divulguent des vitrages comprenant des couches de contrôle solaire multicouches.

Les matériaux actuellement sur le marché ne permettent pas de combiner un facteur solaire bas, notamment inférieur à 20 %, pour une transmission lumineuse d'environ 40 %, une bonne sélectivité (> 2,0) ainsi qu'une faible réflexion côté extérieur.

L'objectif de l'invention est donc de développer un matériau présentant des propriétés de contrôle solaire exceptionnelles et notamment des valeurs de facteur solaire inférieures à 20 % pour une transmission lumineuse de l'ordre de 40 %. Selon l'invention, on cherche donc à minimiser le facteur solaire et à augmenter la sélectivité, tout en gardant une transmission lumineuse adaptée pour permettre une bonne isolation et une bonne vision.

La complexité des empilements comprenant trois couches fonctionnelles à base d'argent rend difficile l'amélioration des performances thermique et des propriétés en réflexion sans nuire aux autres propriétés de l'empilement.

Le demandeur a découvert de manière surprenante qu'en optimisant les épaisseurs des trois couches fonctionnelles et les épaisseurs des revêtements diélectriques, on obtient un matériau susceptible de présenter les propriétés recherchées.

La solution de l'invention représente un excellent compromis entre les performances optiques, thermiques, la transparence et l'aspect esthétique.

L'invention a pour objet un matériau comprenant un substrat transparent revêtu d'un empilement de couches minces comportant successivement à partir du substrat une alternance de trois couches métalliques fonctionnelles à base d'argent dénommées en partant du substrat première, deuxième et troisième couches fonctionnelles et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, caractérisé en ce que :
- l'épaisseur de la première couche fonctionnelle est inférieure à l'épaisseur de la deuxième couche fonctionnelle,
- l'épaisseur de la première couche fonctionnelle est inférieure à l'épaisseur de la troisième couche fonctionnelle,
- le rapport de l'épaisseur de la troisième couche métallique fonctionnelle sur l'épaisseur de la deuxième couche fonctionnelle est compris entre 0,90 et 1,10 en incluant ces valeurs, de préférence compris entre 0,95 et 1,05,
- les revêtements diélectriques M1, M2, M3 et M4 ont chacun une épaisseur optique Eo1, Eo2, Eo3 et Eo4 satisfaisant la relation suivante : Eo4 < Eo1 < Eo2 < Eo3,
- l'épaisseur optique Eo1 du revêtement diélectrique M1 est comprise de 80 à 140 nm,
- l'épaisseur optique Eo2 du revêtement diélectrique M2 est comprise de 100 à 170 nm,
- l'épaisseur optique Eo3 du revêtement diélectrique M3 est comprise de 120 à 140 nm,
- l'épaisseur optique Eo4 du revêtement diélectrique M4 est comprise de 70 à 120 nm.

L'invention concerne également :
- le procédé d'obtention d'un matériau selon l'invention,
- le vitrage comprenant au moins un matériau selon l'invention,
- l'utilisation d'un vitrage selon l'invention en tant que vitrage de contrôle solaire pour le bâtiment ou les véhicules,
- un bâtiment ou un véhicule comprenant un vitrage selon l'invention.

En modulant les épaisseurs des couches fonctionnelles et des revêtements diélectriques, la transparence du vitrage peut être contrôlée de façon à obtenir des valeurs de transmission lumineuse TL de l'ordre de 40 %, gamme adaptée tout particulièrement pour les vitrages destinés à être utilisés dans des régions à fort ensoleillement. Mais l'avantage majeur de l'invention est que l'obtention de l'aspect visuel satisfaisant avec notamment des couleurs en réflexion extérieure particulières ainsi que des valeurs de réflexion extérieure suffisamment basses ne s'opèrent pas au détriment des performances de protection solaire. Les excellentes performances énergétiques sont maintenues sans nécessiter de modifications substantielles des autres paramètres de l'empilement tels que la nature, l'épaisseur et la séquence des couches le constituant.

Les caractéristiques préférées qui figurent dans la suite de la description sont applicables aussi bien au procédé selon l'invention que, le cas échéant, aux produits, c'est-à-dire aux matériaux ou aux vitrages comprenant le matériau.

Toutes les caractéristiques lumineuses présentées dans la description sont obtenues selon les principes et méthodes décrits dans la norme européenne EN 410 se rapportant à la détermination des caractéristiques lumineuses et solaires des vitrages utilisés dans le verre pour la construction.

De manière conventionnelle, les indices de réfraction sont mesurés à une longueur d'onde de 550 nm. Les facteurs de transmission lumineuse TL et de réflexion lumineuse RL sont mesurés sous l'illuminant D65 avec un champ de vision de 2°.

Sauf indication contraire, toutes les valeurs et gammes de valeurs des caractéristiques optiques et thermiques sont données pour un vitrage double constitué d'un substrat de type verre sodo-calcique ordinaire de 6 mm portant l'empilement de couche mince, d'un espace intercalaire de 16 mm rempli d'argon à raison de 90 % et d'air à raison de 10 % et d'un autre substrat de type verre sodo-calcique, non-revêtu, d'une épaisseur de 4 mm. Le substrat revêtu est placé de sorte que l'empilement de couches minces se trouve en face 2 du vitrage. La réflexion extérieure Rext. est observée du côté du substrat comprenant l'empilement, tandis que la réflexion observée du côté du substrat ne comprenant pas l'empilement est désignée comme la réflexion intérieure. La transmission lumineuse (TL) des substrats de type verre sodo-calcique ordinaire, sans empilement est supérieure à 89 %, de préférence de 90 %.

Sauf mention contraire, les épaisseurs évoquées dans le présent document sans autres précisions sont des épaisseurs physiques, réelles ou géométriques dénommées Ep et sont exprimées en nanomètres (et non pas des épaisseurs optiques). L'épaisseur optique Eo est définie comme l'épaisseur physique de la couche considérée multipliée par son indice de réfraction à la longueur d'onde de 550 nm : Eo = n*Ep. L'indice de réfraction étant une valeur adimensionnelle, on peut considérer que l'unité de l'épaisseur optique est celle choisie pour l'épaisseur physique.

Si un revêtement diélectrique est composé de plusieurs couches diélectriques, l'épaisseur optique du revêtement diélectrique correspond à la somme des épaisseurs optiques des différentes couches diélectriques constituant le revêtement diélectrique.

Dans toute la description le substrat selon l'invention est considéré posé horizontalement. L'empilement de couches minces est déposé au-dessus du substrat. Le sens des expressions « au-dessus » et « en-dessous » et « inférieur » et « supérieur » est à considérer par rapport à cette orientation. A défaut de stipulation spécifique, les expressions « au-dessus » et « en-dessous » ne signifient pas nécessairement que deux couches et/ou revêtements sont disposés au contact l'un de l'autre. Lorsqu'il est précisé qu'une couche est déposée « au contact » d'une autre couche ou d'un revêtement, cela signifie qu'il ne peut y avoir une (ou plusieurs) couche(s) intercalée(s) entre ces deux couches (ou couche et revêtement).

Au sens de la présente invention, les qualifications « première », « deuxième », « troisième » et « quatrième » pour les couches fonctionnelles ou les revêtements diélectriques sont définies en partant du substrat porteur de l'empilement et en se référant aux couches ou revêtements de même fonction. Par exemple, la couche fonctionnelle la plus proche du substrat est la première couche fonctionnelle, la suivante en s'éloignant du substrat est la deuxième couche fonctionnelle, etc.

De préférence, l'empilement est déposé par pulvérisation cathodique assistée par un champ magnétique (procédé magnétron). Selon ce mode de réalisation avantageux, toutes les couches de l'empilement sont déposées par pulvérisation cathodique assistée par un champ magnétique.

L'invention concerne également le procédé d'obtention d'un matériau selon l'invention, dans lequel on dépose les couches de l'empilement par pulvérisation cathodique magnétron.

Les couches fonctionnelles métalliques à base d'argent comprennent au moins 95,0 %, de préférence au moins 96,5 % et mieux au moins 98,0 % en masse d'argent par rapport à la masse de la couche fonctionnelle. De préférence, la couche métallique fonctionnelle à base d'argent comprend moins de 1,0 % en masse de métaux autres que de l'argent par rapport à la masse de la couche fonctionnelle à base d'argent.

Selon des modes de réalisation avantageux de l'invention, les couches métalliques fonctionnelles satisfont une ou plusieurs des conditions suivantes :
- les trois couches métalliques fonctionnelles correspondent à la première, à la deuxième et à la troisième couche fonctionnelle métallique définies en partant du substrat,
- le rapport de l'épaisseur de la troisième couche métallique fonctionnelle sur l'épaisseur de la deuxième couche fonctionnelle est compris entre 0,90 et 1,10 en incluant ces valeurs, de préférence 0,95 et 1,05, et/ou
- l'épaisseur de la première couche métallique fonctionnelle est, par ordre de préférence croissant, comprise entre 6 et 12 nm, entre 7 et 11 nm, entre 8 et 10 nm, et/ou
- l'épaisseur de la deuxième couche fonctionnelle est supérieure à 15 nm, et/ou
- l'épaisseur de la seconde couche métallique fonctionnelle est, par ordre de préférence croissant, comprise entre 15 et 20 nm, entre 16 et 18 nm, et/ou
- l'épaisseur de la troisième couche métallique fonctionnelle est, par ordre de préférence croissant, comprise entre 15 et 20 nm, entre 16 et 18 nm.

Ces plages d'épaisseur pour les couches métalliques fonctionnelles sont les plages pour lesquelles les meilleurs résultats sont obtenus pour une transmission lumineuse en double vitrage d'environ 40 %, une réflexion lumineuse et un facteur solaire bas. On obtient ainsi une sélectivité élevée et des couleurs en réflexion de l'extérieur neutre.

L'empilement peut comprendre en outre au moins une couche de blocage située au contact d'une couche fonctionnelle.

Les couches de blocage ont traditionnellement pour fonction de protéger les couches fonctionnelles d'une éventuelle dégradation lors du dépôt du revêtement diélectrique supérieur et lors d'un éventuel traitement thermique à haute température, du type recuit, bombage et/ou trempe.

Les couches de blocage sont choisies parmi les couches métalliques à base d'un métal ou d'un alliage métallique, les couches de nitrure métallique, les couches d'oxyde métallique et les couches d'oxynitrure métallique d'un ou plusieurs éléments choisis parmi le titane, le nickel, le chrome et le niobium telles que Ti, TiN, TiOx, Nb, NbN, Ni, NiN, Cr, CrN, NiCr, NiCrN. Lorsque ces couches de blocage sont déposées sous forme métallique, nitrurée ou oxynitrurée, ces couches peuvent subir une oxydation partielle ou totale selon leur épaisseur et la nature des couches qui les entourent, par exemple, au moment du dépôt de la couche suivante ou par oxydation au contact de la couche sous-jacente.

Selon des modes de réalisation avantageux de l'invention, la ou les couches de blocage satisfont une ou plusieurs des conditions suivantes :
- chaque couche métallique fonctionnelle est au contact d'au moins une couche de blocage choisie parmi une sous-couche de blocage et une surcouche de blocage, et/ou
- chaque couche métallique fonctionnelle est au contact d'une sous-couche de blocage et d'une surcouche de blocage, et/ou
- l'épaisseur de chaque couche de blocage est d'au moins 0,1 nm, de préférence comprise entre 0,5 et 2,0 nm, et/ou
- l'épaisseur totale de toutes les couches de blocage au contact des couches fonctionnelles est comprise entre 3 et 8 nm en incluant ces valeurs, de préférence entre 4 et 7 nm, voire 5 et 6 nm.

Selon des modes de réalisation avantageux de l'invention, les revêtements diélectriques satisfont une ou plusieurs des conditions suivantes en termes d'épaisseurs :
- l'épaisseur optique du premier revêtement diélectrique M1 est, par ordre de préférence croissant, comprise de 80 à 140 nm, de 90 à 130 nm, de 95 à 125 nm, et/ou
- l'épaisseur physique du premier revêtement diélectrique M1 est, par ordre de préférence croissant, comprise de 30 à 80 nm, de 40 à 70 nm, de 45 à 65 nm, et/ou
- l'épaisseur optique du deuxième revêtement diélectrique M2 est, par ordre de préférence croissant, comprise de 100 à 170 nm, de 130 à 160 nm, de 140 à 150 nm, et/ou
- l'épaisseur physique du deuxième revêtement diélectrique M2 est, par ordre de préférence, croissant comprise de 40 à 100 nm, de 50 à 80 nm, de 65 à 75 nm, et/ou
- l'épaisseur optique du troisième revêtement diélectrique M3 est, par ordre de préférence croissant, comprise de 120 à 240 nm, de 140 à 220 nm, de 155 à 210 nm, de 180 à 200 nm, et/ou
- l'épaisseur physique du troisième revêtement diélectrique M3 est, par ordre de préférence croissant, comprise de 60 à 120 nm, de 80 à 110 nm, de 90 à 100 nm, et/ou
- l'épaisseur optique du quatrième revêtement diélectrique M4 est, par ordre de préférence croissant, comprise de 70 à 120 nm, de 70 à 110 nm, de 80 à 100 nm, et/ou
- l'épaisseur physique du quatrième revêtement diélectrique M4 est, par ordre de préférence croissant, comprise de 20 à 60 nm, de 30 à 55 nm, de 40 à 50 nm.

Selon des modes de réalisation avantageux de l'invention, les revêtements diélectriques satisfont une ou plusieurs des conditions suivantes :
- les revêtements diélectriques comprennent au moins une couche diélectrique à base d'oxyde ou de nitrure d'un ou plusieurs éléments choisis parmi le silicium, le titane, le zirconium, l'aluminium, l'étain, le zinc, et/ou
- au moins un revêtement diélectrique comporte au moins une couche diélectrique à fonction barrière, et/ou
- chaque revêtement diélectrique comporte au moins une couche diélectrique à fonction barrière, et/ou
- les couches diélectriques à fonction barrière à base de composés de silicium et/ou d'aluminium choisis parmi les oxydes tels que SiO₂ et Al₂O₃, les nitrures de silicium Si₃N₄ et AlN et les oxynitures SiOₓN_{y} et AlOₓN_{y}. et/ou
- les couches diélectriques à fonction barrière sont à base de composés de silicium et/ou d'aluminium comprennent éventuellement au moins un autre élément, comme l'aluminium, le hafnium et le zirconium, et/ou
- au moins un revêtement diélectrique comprend au moins une couche diélectrique à fonction stabilisante, et/ou
- chaque revêtement diélectrique comprend au moins une couche diélectrique à fonction stabilisante, et/ou
- les couches diélectriques à fonction stabilisante sont de préférence à base d'oxyde choisi parmi l'oxyde de zinc, l'oxyde d'étain, l'oxyde de zirconium ou un mélange d'au moins deux d'entre eux,
- les couches diélectriques à fonction stabilisante sont de préférence à base d'oxyde cristallisé, notamment à base d'oxyde de zinc, éventuellement dopé à l'aide d'au moins un autre élément, comme l'aluminium, et/ou
- chaque couche fonctionnelle est au-dessus d'un revêtement diélectrique dont la couche supérieure est une couche diélectrique à fonction stabilisante, de préférence à base d'oxyde de zinc et/ou en-dessous d'un revêtement diélectrique dont la couche inférieure est une couche diélectrique à fonction stabilisante, de préférence à base d'oxyde de zinc,
- au moins un revêtement diélectrique situé en dessous d'une couche métallique fonctionnelle comporte au moins une couche diélectrique à fonction de lissage, et/ou
- chaque revêtement diélectrique situé en dessous d'une couche métallique fonctionnelle comporte au moins une couche diélectrique à fonction de lissage, et/ou
- les couches diélectriques à fonction de lissage sont de préférence à base d'oxyde mixte d'au moins deux métaux choisis parmi Sn, Zn, In, Ga, et/ou
- les couches diélectriques à fonction de lissage sont de préférence des couches d'oxyde mixte de zinc et d'étain éventuellement dopées.

De préférence, chaque revêtement diélectrique est constitué uniquement d'une ou de plusieurs couches diélectriques. De préférence, il n'y a donc pas de couche absorbante dans les revêtements diélectriques afin de ne pas diminuer la transmission lumineuse.

Les empilements de l'invention peuvent comprendre des couches diélectriques à fonction barrière. On entend par couches diélectriques à fonction barrière, une couche en un matériau apte à faire barrière à la diffusion de l'oxygène et de l'eau à haute température, provenant de l'atmosphère ambiante ou du substrat transparent, vers la couche fonctionnelle. Les matériaux constitutifs de la couche diélectrique à fonction barrière ne doivent donc pas subir de modification chimique ou structurelle à haute température qui entraînerait une modification de leurs propriétés optiques. La ou les couches à fonction barrière sont de préférence également choisies en un matériau apte à faire barrière au matériau constitutif de la couche fonctionnelle. Les couches diélectriques à fonction barrière permettent donc à l'empilement de subir sans évolution optique trop significative des traitements thermiques du type recuit, trempe ou bombage

Les empilements de l'invention peuvent comprendre des couches diélectriques à fonction stabilisante. Au sens de l'invention, « stabilisante » signifie que l'on sélectionne la nature de la couche de façon à stabiliser l'interface entre la couche fonctionnelle et cette couche. Cette stabilisation conduit à renforcer l'adhérence de la couche fonctionnelle aux couches qui l'entourent, et de fait elle va s'opposer à la migration de son matériau constitutif.

La ou les couches diélectriques à fonction stabilisante peuvent se trouver directement au contact d'une couche fonctionnelle ou séparées par une couche de blocage.

De préférence, la dernière couche diélectrique de chaque revêtement diélectrique situé en-dessous d'une couche fonctionnelle est une couche diélectrique à fonction stabilisante. En effet, il est avantageux d'avoir une couche à fonction stabilisante, par exemple, à base d'oxyde de zinc en-dessous d'une couche fonctionnelle, car elle facilite l'adhésion et la cristallisation de la couche fonctionnelle à base d'argent et augmente sa qualité et sa stabilité à haute température.

Il est également avantageux d'avoir une couche fonction stabilisante, par exemple, à base d'oxyde de zinc au-dessus d'une couche fonctionnelle, pour en augmenter l'adhésion et s'opposer de manière optimale à la diffusion du côté de l'empilement opposé au substrat.

La ou les couches diélectriques à fonction stabilisantes peuvent donc se trouver au-dessus et/ou en dessous d'au moins une couche fonctionnelle ou de chaque couche fonctionnelle, soit directement à son contact ou soit séparées par une couche de blocage.

Avantageusement, chaque couche diélectrique à fonction barrière est séparée d'une couche fonctionnelle par au moins une couche diélectrique à fonction stabilisante.

Cette couche diélectrique à fonction stabilisante peut avoir une épaisseur d'au moins 4 nm, notamment une épaisseur comprise entre 4 et 10 nm et mieux de 8 à 10 nm.

L'empilement de couches minces peut éventuellement comprendre une couche de lissage. On entend par couches de lissage, une couche dont la fonction est de favoriser la croissance de la couche stabilisante selon une orientation cristallographique préférentielle, laquelle favorise la cristallisation de la couche d'argent par des phénomènes d'épitaxie. La couche de lissage est située en-dessous et de préférence au-contact d'une couche stabilisante.

La couche de lissage à base d'oxyde mixte peut être qualifiée de « non cristallisée » dans le sens où elle peut être complètement amorphe ou partiellement amorphe et ainsi partiellement cristallisée, mais qu'elle ne peut pas être complètement cristallisée, sur toute son épaisseur. Elle ne peut être de nature métallique car elle est à base d'oxyde mixte (un oxyde mixte est un oxyde d'au moins deux éléments).

L'empilement de couches minces peut éventuellement comprendre une couche de protection. La couche de protection est de préférence la dernière couche de l'empilement, c'est-à-dire la couche la plus éloignée du substrat revêtu de l'empilement. Ces couches supérieures de protection sont considérées comme comprises dans le quatrième revêtement diélectrique. Ces couches ont en général une épaisseur comprise entre 2 et 10 nm, de préférence 2 et 5 nm. Cette couche de protection peut être choisie parmi une couche de titane, de zirconium, d'hafnium, de zinc et/ou d'étain, ce ou ces métaux étant sous forme métallique, oxydée ou nitrurée.

La couche de protection peut par exemple être choisie parmi une couche d'oxyde de titane, une couche d'oxyde de zinc et d'étain ou une couche d'oxyde de titane et de zirconium.

Un mode de réalisation particulièrement avantageux concerne un substrat revêtu d'un empilement défini en partant du substrat transparent comprenant :
- un premier revêtement diélectrique comprenant au moins une couche diélectrique à fonction barrière et une couche diélectrique à fonction stabilisante,
- éventuellement une couche de blocage,
- une première couche fonctionnelle,
- éventuellement une couche de blocage,
- un deuxième revêtement diélectrique comprenant au moins un couche diélectrique à fonction stabilisante inférieure, une couche diélectrique à fonction barrière et une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins un couche diélectrique à fonction stabilisante inférieure, une couche diélectrique à fonction barrière et une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante, une couche diélectrique à fonction barrière et éventuellement une couche de protection.

Les substrats transparents selon l'invention sont de préférence en un matériau rigide minéral, comme en verre, ou organiques à base de polymères (ou en polymère).

Les substrats transparents organiques selon l'invention peuvent également être en polymère, rigides ou flexibles. Des exemples de polymères convenant selon l'invention comprennent, notamment :
- le polyéthylène,
- les polyesters tels que le polyéthylène téréphtalate (PET), le polybutylène téréphtalate (PBT), le polyéthylène naphtalate (PEN) ;
- les polyacrylates tels que le polyméthacrylate de méthyle (PMMA) ;
- les polycarbonates ;
- les polyuréthanes ;
- les polyamides ;
- les polyimides ;
- les polymères fluorés comme les fluoroesters tels que l'éthylène tétrafluoroéthylène (ETFE), le polyfluorure de vinylidène (PVDF), le polychlorotrifluorethylène (PCTFE), l'éthylène de chlorotrifluorethylène (ECTFE), les copolymères éthylène-propylène fluores (FEP) ;
- les résines photoréticulables et/ou photopolymérisables, telles que les résines thiolène, polyuréthane, uréthane-acrylate, polyester-acrylate et
- les polythiouréthanes.

Le substrat est de préférence une feuille de verre ou de vitrocéramique.

Le substrat est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate.

Le substrat possède avantageusement au moins une dimension supérieure ou égale à 1 m, voire 2 m et même 3 m. L'épaisseur du substrat varie généralement entre 0,5 mm et 19 mm, de préférence entre 0,7 et 9 mm, notamment entre 2 et 8 mm, voire entre 4 et 6 mm. Le substrat peut être plan ou bombé, voire flexible.

Le matériau, c'est-à-dire le substrat revêtu de l'empilement, peut subir un traitement thermique à température élevée tel qu'un recuit, par exemple par un recuit flash tel qu'un recuit laser ou flammage, une trempe et/ou un bombage. La température du traitement thermique est supérieure à 400 °C, de préférence supérieure à 450 °C, et mieux supérieure à 500 °C. Le substrat revêtu de l'empilement peut donc être bombé et/ou trempé.

L'invention concerne également un vitrage comprenant un matériau selon l'invention. De manière conventionnelle, les faces d'un vitrage sont désignées à partir de l'extérieur du bâtiment et en numérotant les faces des substrats de l'extérieur vers l'intérieur de l'habitacle ou du local qu'il équipe. Cela signifie que la lumière solaire incidente traverse les faces dans l'ordre croissant de leur numéro.

L'empilement est de préférence positionné dans le vitrage de sorte que la lumière incidente provenant de l'extérieur traverse le premier revêtement diélectrique avant de traverser la première couche métallique fonctionnelle. L'empilement n'est pas déposé sur la face du substrat définissant la paroi extérieure du vitrage mais sur la face intérieure de ce substrat. L'empilement est donc avantageusement positionné en face 2, la face 1 du vitrage étant la face la plus à l'extérieur du vitrage, comme habituellement.

Le matériau peut être destiné à des applications nécessitant que le substrat revêtu de l'empilement ait subi un traitement thermique à une température élevée tel qu'une trempe, un recuit ou un bombage.

Le vitrage de l'invention peut être sous forme de vitrage monolithique, feuilleté ou multiple, en particulier double vitrage ou triple vitrage.

Dans le cas d'un vitrage monolithique ou multiple, l'empilement est de préférence déposé en face 2, c'est-à-dire qu'il se trouve sur le substrat définissant la paroi extérieure du vitrage et plus précisément sur la face intérieure de ce substrat.

Un vitrage monolithique comporte 2 faces, la face 1 est à l'extérieur du bâtiment et constitue donc la paroi extérieure du vitrage, la face 2 est à l'intérieur du bâtiment et constitue donc la paroi intérieure du vitrage.

Un vitrage multiple comprend au moins deux substrats maintenus à distance de manière à délimiter une cavité remplie par un gaz isolant. Les matériaux selon l'invention conviennent tout particulièrement lorsqu'ils sont utilisés dans des double-vitrages à isolation thermique renforcée (ITR).

Un double vitrage comporte 4 faces, la face 1 est à l'extérieur du bâtiment et constitue donc la paroi extérieure du vitrage, la face 4 est à l'intérieur du bâtiment et constitue donc la paroi intérieure du vitrage, les faces 2 et 3 étant à l'intérieur du double vitrage.

De la même manière, un triple vitrage comporte 6 faces, la face 1 est à l'extérieur du bâtiment (paroi extérieure du vitrage), la face 6 à l'intérieur du bâtiment (paroi intérieure du vitrage) et les faces 2 à 5 sont à l'intérieur du triple vitrage.

Un vitrage feuilleté comporte au moins une structure de type premier substrat / feuille(s) / deuxième substrat. L'empilement de couches minces est positionné sur l'une au moins des faces d'un des substrats. L'empilement peut être sur la face du deuxième substrat non au contact de la feuille, de préférence polymère. Ce mode de réalisation est avantageux lorsque le vitrage feuilleté est monté en double vitrage avec un troisième substrat.

Le vitrage selon l'invention, utilisé comme vitrage monolithique ou dans un vitrage multiple de type double-vitrage, présente des couleurs en réflexion extérieure neutres, agréables et douces, dans la gamme des bleus ou bleus-verts (valeurs de longueur d'onde dominante de l'ordre de 470 à 500 nanomètres). De plus, cet aspect visuel reste quasiment inchangé quel que soit l'angle d'incidence avec lequel le vitrage est observé (incidence normale et sous angle). Cela signifie qu'un observateur n'a pas l'impression d'une inhomogénéité significative de teinte ou d'aspect.

Par « couleur dans le bleu-vert » au sens de la présente invention, il faut comprendre que dans le système de mesure de couleur L*a*b*, a* est compris entre - 10,0 et 0,0, de préférence entre -5,0 et 0,0 et b* est compris entre -10,0 et 0,0, de préférence entre -5,0 et 0,0.

Le vitrage de l'invention présente des couleurs en transmission dans le système de mesure de couleur L*a*b* :
- a* est compris entre -6,0 et 0,0, de préférence entre -5,0 et -1,0,
- b* est compris entre -6,0 et 3,0, de préférence entre -5,0 et 0,0.

Le vitrage de l'invention présente des couleurs en réflexion côté extérieur dans le système de mesure de couleur L*a*b* :
- a* compris entre -5,0 et 0,0, de préférence entre -4,0 et -1,0 et/ou
- b* est compris entre -10,0 et 0,0, de préférence entre -9,0 et -5,0.

Selon des modes de réalisation avantageux, le vitrage de l'invention sous forme d'un double vitrage comprenant l'empilement positionné en face 2 permet d'atteindre notamment les performances suivantes :
- un facteur solaire inférieur ou égal à 20 %, voire inférieur ou égal à 19 %, et/ou
- une transmission lumineuse inférieure à 50 %, de préférence comprise entre 30 % et 50 %, voire comprise entre 35 et 45 % et/ou
- une sélectivité élevée, par ordre de préférence croissant, d'au moins 1,8, d'au moins 1,9, d'au moins 2,0, d'au moins 2,1 et/ou
- une faible émissivité, notamment inférieure à 1 %, et/ou
- une réflexion lumineuse côté extérieur inférieure ou égale à 25 %, de préférence inférieure ou égale à 22,5 %, voire inférieure ou égale à 20 %, et/ou
- des couleurs neutres en réflexion extérieure.

Les détails et caractéristiques avantageuses de l'invention ressortent des exemples non limitatifs suivants, illustrés à l'aide de la figure jointe.

Les proportions entre les différents éléments ne sont pas respectées afin de faciliter la lecture des figures.

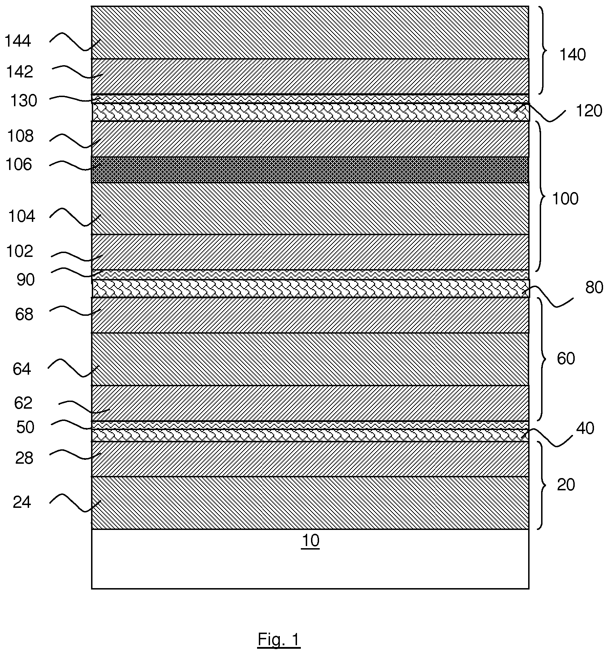

La figure 1 illustre une structure d'empilement à trois couches métalliques fonctionnelles 40, 80, 120, cette structure étant déposée sur un substrat 10 verrier, transparent. Chaque couche fonctionnelle 40, 80, 120 est disposée entre deux revêtements diélectrique 20, 60, 100, 140 de telle sorte que :
- la première couche fonctionnelle 40 en partant du substrat est disposée entre les revêtements diélectrique 20, 60,
- la deuxième couche fonctionnelle 80 est disposée entre les revêtements diélectrique 60, 100 et
- la troisième couche fonctionnelle 120 est disposée entre les revêtements diélectriques 100, 140.

Ces revêtements diélectriques 20, 60, 100, 140 comportent chacun au moins une couche diélectrique 24, 28 ; 62, 64, 68 ; 102, 104, 106, 108 ; 142, 144.

L'empilement peut comprendre également :
- des sous-couches de blocage 30, 70, et 110 (non représentées), situées au contact d'une couche fonctionnelle,
- des surcouches de blocage 50, 90 et 130 situées au contact d'une couche fonctionnelle,
- une couche de protection 160 (non représentée).

### Exemples

### I. Préparation des substrats : Empilements, conditions de dépôt et traitements thermiques

Des empilements de couches minces définis ci-après sont déposés sur des substrats en verre sodo-calcique clair d'une épaisseur de 6 mm.

Dans les exemples de l'invention :
- les couches fonctionnelles sont des couches d'argent (Ag),
- les couches de blocage sont des couches métalliques en alliage de nickel et de chrome (NiCr),
- les couches barrières sont à base de nitrure de silicium, dopé à l'aluminium (Si₃N₄ : Al),
- les couches stabilisantes sont en oxyde de zinc (ZnO),
- les couches de lissages sont à base d'oxyde mixte de zinc et d'étain (SnZnOx),
- les couches de protection sont en oxyde de titane et de zirconium (TiZrOx).

Les conditions de dépôt des couches, qui ont été déposées par pulvérisation (pulvérisation dite « cathodique magnétron »), sont résumées dans le tableau 1.

| **Tab. 1** | Cible employée | Pression de dépôt | Gaz | n 550 nm |
|---|---|---|---|---|
| Si₃N₄ | Si:Al à 92:8 % en poids | 3,2.10-3 mbar | Ar /(Ar + N2) à 55 % | 2,03 |
| ZnO | Zn:Al à 98:2 % en poids | 1,8.10-3 mbar | Ar /(Ar + O2) à 63 % | 1,95 |
| SnZnOx | Sn:Zn (60:40% en pds) | 1,5*10⁻³ mbar | Ar 39 % - O₂ 61 % | 2,09 |
| TiZrO | TiZrOx | 2-4*10⁻³ mbar | Ar 90 % -O₂ 10 % | 2,32 |
| NiCr | Ni (80% at.) : Cr (20% at.) | 2-3.10⁻³ mbar | Ar à 100 % | - |
| Ag | Ag | 3.10-3 mbar | Ar à 100 % | - |

| | | | | |
|---|---|---|---|---|
| At. = atomique | | | | |

Le tableau 2 liste les matériaux et les épaisseurs physiques en nanomètres (sauf autre indication) de chaque couche ou revêtement qui constitue les empilements en fonction de leur position vis-à-vis du substrat porteur de l'empilement (dernière ligne en bas du tableau). Les numéros « Réf. » correspondent aux références de la figure 1.

| **Tab. 2** | Réf. | Inv.1 | Inv.2 | Inv.3 | Inv.4 | Comp.1 | Comp.2 |
|---|---|---|---|---|---|---|---|
| Revêtement diélectrique M4 | 140 | 43,2 | 41,1 | 42 | 45,8 | 33 | 33 |
| - TiZrOx | 160 | 2 | 2 | 2 | 2 | 2 | 2 |
| - Si₃N₄ | 144 | 33,2 | 31,1 | 32 | 35,8 | 26 | 27 |
| - ZnO | 142 | 8 | 8 | 8 | 8 | 5 | 4 |
| Couche blocage NiCr | 130 | 1,3 | 1,1 | 0,8 | 1,2 | 1,2 | 1,2 |
| Couche fonctionnelle Ag3 | 120 | 16,5 | 17,2 | 17,3 | 17,6 | 18,3 | 16,9 |
| Couche blocage NiCr | 110 | 0,5 | 0,5 | 0,5 | 0,5 | 0 | 0 |
| Revêtement diélectrique M3 | 100 | 93,7 | 92,6 | 90,8 | 90,5 | 81 | 68,5 |
| -ZnO | 108 | 8 | 8 | 8 | 8 | 12 | 13 |
| - SnZnO | 106 | - | - | - | - | 10 | 11,5 |
| - Si₃N₄ | 104 | 77,7 | 76,6 | 74,8 | 74,5 | 54 | 40 |
| - ZnO | 102 | 8 | 8 | 8 | 8 | 5 | 4 |
| Couche blocage NiCr | 90 | 0,5 | 0,5 | 0,5 | 0,5 | 2 | 0,9 |
| Couche fonctionnelle Ag2 | 80 | 16,5 | 17,1 | 16,8 | 16,7 | 13,8 | 12,4 |
| Couche blocage NiCr | 70 | 1,7 | 1,8 | 1,5 | 0,5 | 0 | 0 |
| Revêtement diélectrique M2 | 60 | 71,3 | 71,5 | 70,7 | 69,8 | 72 | 66 |
| - ZnO | 68 | 8 | 8 | 8 | 8 | 11 | 7 |
| - Si₃N₄ | 64 | 55,3 | 55,5 | 54,7 | 53,8 | 57 | 56 |
| - ZnO | 62 | 8 | 8 | 8 | 8 | 4 | 3 |
| Couche blocage NiCr | 50 | 0,5 | 0,5 | 1,3 | 2,2 | 1,8 | 0,8 |
| Couche fonctionnelle Ag1 | 40 | 9,7 | 10,1 | 9,4 | 8,1 | 7,7 | 8,9 |
| Couche blocage NiCr | 30 | 0,7 | 0,5 | 0,5 | 0,5 | 0 | 0 |
| Revêtement diélectrique M1 | 20 | 52,1 | 48,9 | 50,8 | 59,5 | 68 | 35 |
| - ZnO | 28 | 8 | 8 | 8 | 8 | 9 | 7 |
| - Si₃N₄ | 24 | 44,1 | 40,9 | 42,8 | 51,5 | 59 | 28 |
| Substrat verre (mm) | 10 | 6 | 6 | 6 | 6 | 6 | 6 |

Chaque revêtement diélectrique 20, 60, 100 en-dessous d'une couche fonctionnelle 40, 80, 120 comporte une dernière couche stabilisante 28, 68, 108 à base d'oxyde de zinc cristallisé, et qui est au contact de la couche fonctionnelle 40, 80, 120 déposée juste au-dessus.

Chaque revêtement diélectrique 60, 100, 140 au-dessus d'une couche fonctionnelle 40, 80, 120 comporte une première couche stabilisante 62, 102, 142 à base d'oxyde de zinc cristallisé, et qui est au contact de la couche fonctionnelle 40, 80, 120 déposée juste au-dessus.

Chaque revêtement diélectrique 20, 60, 100, 140 comporte une couche diélectrique à fonction barrière 24, 64, 104, 144, à base de nitrure de silicium, dopé à l'aluminium appelée ici Si₃N₄.

Le revêtement diélectrique 100 comporte en outre une couche de lissage à base d'oxyde mixte de zinc et d'étain 106.

Chaque couche fonctionnelle métallique 40, 80, 120 est au-dessus d'une couche de blocage 30, 70 et 110 (non représentées sur la figure 1) et en-dessous et au contact d'une couche de blocage 50, 90 et 130.

L'empilement comprend en outre une couche de protection en oxyde de titane et de zirconium 160 (non représentée sur la figure 1).

Le tableau 3 suivant résume les caractéristiques liées aux épaisseurs des couches fonctionnelles et des revêtements diélectriques.

| **Tab. 3** | **Inv.1** | | **Inv.2** | | **Inv.3** | | **Inv.4** | | **Comp.1** | | **Comp.2** | |
|---|---|---|---|---|---|---|---|---|---|---|---|---|
| RD | Ep | Eo | Ep | Eo | Ep | Eo | Ep | Eo | Ep | Eo | Ep | Eo |
| M1 | 52,1 | 105,1 | 48,9 | 98,6 | 50, 8 | 102,5 | 59, 5 | 120, 1 | 68 | 137,3 | 35 | 70,5 |
| M2 | 71,3 | 143,5 | 71,5 | 143,9 | 70, 7 | 142,2 | 69, 8 | 140, 4 | 72 | 145,0 | 66 | 133, 2 |
| M3 | 93,7 | 188,9 | 92,6 | 186,7 | 90, 8 | 183,0 | 90, 5 | 182, 4 | 81 | 163,7 | 68,5 | 138, 4 |
| M4 | 43,2 | 87,6 | 41,1 | 83,4 | 42 | 85,2 | 45, 8 | 92,9 | 33 | 67,2 | 33 | 67,3 |
| Ag3/Ag2 | 1,00 | | 1,01 | | 1,03 | | 1,05 | | 1,33 | | 1,36 | |
| Ag2>15nm | oui | | oui | | oui | | oui | | non | | non | |
| Σ Ep CB | 5,20 | | 4,90 | | 5,10 | | 5,40 | | 5,00 | | 2,90 | |

| | | | | | | | | | | | | |
|---|---|---|---|---|---|---|---|---|---|---|---|---|
| RD : Revêtement diélectrique ; CB : Couche de blocage ; Ep : Epaisseur physique ; Eo : Epaisseur optique. | | | | | | | | | | | | |

### II. Performances « contrôle solaire » et colorimétrie

Le tableau 4 liste les principales caractéristiques optiques mesurées lorsque les vitrages font parties de double vitrage de structure 6/16/4 : verre de 6 mm / espace intercalaire de 16 mm rempli de 90 % d'argon et 10 % d'air / verre de 4 mm, l'empilement étant positionné en face 2 (la face 1 du vitrage étant la face la plus à l'extérieur du vitrage, comme habituellement).

Pour ces doubles vitrages :
- TL indique : la transmission lumineuse dans le visible en %, mesurée selon l'illuminant D65 à 2° Observateur ;
- a*T et b*T indiquent les couleurs en transmission a* et b* dans le système L*a*b* mesurées selon l'illuminant D65 à 2° Observateur et mesurées perpendiculairement au vitrage ;
- RLext indique : la réflexion lumineuse dans le visible en %, mesurée selon l'illuminant D65 à 2° Observateur du côté de la face la plus à l'extérieur, la face 1 ;
- a*Rext et b*Rext indiquent les couleurs en réflexion a* et b* dans le système L*a*b* mesurées selon l'illuminant D65 à 2° Observateur du côté de la face la plus à l'extérieur et mesurées ainsi perpendiculairement au vitrage,
- RLint indique : la réflexion lumineuse dans le visible en %, mesurée selon l'illuminant D65 à 2° Observateur du côté de la face intérieur, la face 4 ;
- a*Rint et b*Rint indiquent les couleurs en réflexion a* et b* dans le système L*a*b* mesurées selon l'illuminant D65 à 2° Observateur du côté de la face intérieur et mesurées ainsi perpendiculairement au vitrage.

Les valeurs colorimétriques en angle a*g60° et b*g60° sont mesurées sur simple vitrage sous incidence de 60°. Cela rend compte de la neutralité des couleurs en angle.

| **Tab. 4** | **Valeur cible** | **Inv.1** | **Inv.2** | **Inv.3** | **Inv.4** | **Comp.1** | **Comp.2** |
|---|---|---|---|---|---|---|---|
| « g »% | ≤20% | 19 | **19** | 19 | 19 | 22 | 28 |
| « s » | > 2,0 | 2,1 | 2,1 | 2,1 | 2,1 | 2,3 | 2,1 |
| TL% | ≈ 40 % | 40 | 40 | 40 | 40 | 50 | 60 |
| - a*T | <0 | -4,5 | -5,0 | -4,7 | -5,7 | -7,0 | -6,9 |
| - b*T | - | -0,1 | 0,0 | -1,4 | 2,0 | ,05 | 3,0 |
| RLext% | < 20 % | 18 | 18 | 14 | 12 | 17 | 15 |
| - a*Rext | <0 | -2,4 | -2,7 | -2,2 | -2,8 | -6,5 | -3,1 |
| - b*Rext | <0 | -6,6 | -7,0 | -7,0 | -9,0 | -8,5 | -8,9 |
| RLint% | - | 22 | 21 | 20 | 20 | 20 | 19 |
| - a*Rint | <0 | -11,0 | -13,0 | -13,0 | -13,2 | -8,0 | -3,8 |
| - b*Rint | <0 | -10,8 | -13,1 | -13,0 | -13,5 | -8,0 | -3,0 |
| - a*g60° | - | -6,5 | -4,7 | -4,0 | -1,2 | -4,2 | -4,2 |
| - b*g60° | - | -1,1 | -1,9 | -1,2 | -2,4 | -1,2 | -1,2 |

Les exemples selon l'invention présentent tous une coloration en transmission agréable et douce, de préférence dans la gamme des bleus ou bleus-verts.

Les vitrages selon l'invention présentent à la fois un facteur solaire inférieur ou égal à 20 % et une sélectivité supérieure à 2,0. Ces vitrages présentent en plus une réflexion extérieure au moins inférieure à 20 %.

La solution proposée permet donc d'avoir un facteur solaire inférieur à 20% en gardant une sélectivité supérieure à 2,0 et une esthétique favorable.

Les exemples selon l'invention 3 et 4 sont particulièrement avantageux car il présente en plus d'un facteur solaire bas et d'une sélectivité élevée, des valeurs de réflexion lumineuse côté extérieure extrêmement faibles notamment inférieures à 15 %.

## Revendications

1. Matériau comprenant un substrat transparent revêtu d'un empilement de couches minces comportant successivement à partir du substrat une alternance de trois couches métalliques fonctionnelles à base d'argent dénommées en partant du substrat première, deuxième et troisième couches fonctionnelles et de quatre revêtements diélectriques dénommés en partant du substrat M1, M2, M3 et M4, chaque revêtement diélectrique comportant au moins une couche diélectrique, de manière à ce que chaque couche métallique fonctionnelle soit disposée entre deux revêtements diélectriques, **caractérisé en ce que** :
- le matériau présente une transmission lumineuse inférieure à 50 %,
- l'épaisseur de la première couche fonctionnelle est inférieure à l'épaisseur de la deuxième couche fonctionnelle,
- l'épaisseur de la première couche fonctionnelle est inférieure à l'épaisseur de la troisième couche fonctionnelle,
- le rapport de l'épaisseur de la troisième couche métallique fonctionnelle sur l'épaisseur de la deuxième couche fonctionnelle est compris entre 0,90 et 1,10 en incluant ces valeurs,
- les revêtements diélectriques M1, M2, M3 et M4 ont chacun une épaisseur optique Eo1, Eo2, Eo3 et Eo4 satisfaisant la relation suivante : Eo4 < Eo1 < Eo2 < Eo3,
- l'épaisseur optique Eo1 du revêtement diélectrique M1 est comprise de 80 à 140 nm,
- l'épaisseur optique Eo2 du revêtement diélectrique M2 est comprise de 100 à 170 nm,
- l'épaisseur optique Eo3 du revêtement diélectrique M3 est comprise de 120 à 240 nm,
- l'épaisseur optique Eo4 du revêtement diélectrique M4 est comprise de 70 à 120 nm.

2. Matériau selon la revendication 1 **caractérisé en ce que** l'épaisseur de la deuxième couche fonctionnelle est supérieure à 15 nm.

3. Matériau selon l'une des revendications précédentes, **caractérisé en ce que** les trois couches métalliques fonctionnelles satisfont les caractéristiques suivantes :
- l'épaisseur de la première couche métallique fonctionnelle est comprise entre 6 et 12 nm,
- l'épaisseur de la seconde couche métallique fonctionnelle est comprise entre 15 et 20 nm,
- l'épaisseur de la troisième couche métallique fonctionnelle est comprise entre 15 et 20 nm.

4. Matériau selon l'une quelconque des revendications précédentes, **caractérisé en ce que** l'empilement comprend en outre au moins une couche de blocage située au contact d'une couche métallique fonctionnelle choisies parmi les couches métalliques à base d'un métal ou d'un alliage métallique, les couches de nitrure métallique, les couches d'oxyde métallique et les couches d'oxynitrure métallique d'un ou plusieurs éléments choisis parmi le titane, le nickel, le chrome et le niobium telles qu'une couche de Ti, TiN, TiOx, Nb, NbN, Ni, NiN, Cr, CrN, NiCr, NiCrN.

5. Matériau selon la revendication précédente, **caractérisé en ce que** l'épaisseur totale de toutes les couches de blocage au contact des couches fonctionnelles est comprise entre 4 et 7 nm en incluant ces valeurs.

6. Matériau selon l'une quelconque des revendications précédentes, **caractérisé en ce que** chaque revêtement diélectrique comporte au moins une couche diélectrique à fonction barrière à base de composés de silicium et/ou d'aluminium choisis parmi les oxydes tels que SiO₂ et Al₂O₃, les nitrures de silicium Si₃N₄ et AIN et les oxynitrures SiOₓN_{y} et AlOₓN_{y}.

7. Matériau selon l'une quelconque des revendications précédentes, **caractérisé en ce que** chaque revêtement diélectrique comporte au moins une couche diélectrique à fonction stabilisante à base d'oxyde cristallisé, notamment à base d'oxyde de zinc, éventuellement dopé à l'aide d'au moins un autre élément, comme l'aluminium.

8. Matériau selon l'une quelconque des revendications précédentes, **caractérisé en ce que** chaque couche fonctionnelle est au-dessus d'un revêtement diélectrique dont la couche supérieure est une couche diélectrique à fonction stabilisante, de préférence à base d'oxyde de zinc et/ou en-dessous d'un revêtement diélectrique dont la couche inférieure est une couche diélectrique à fonction stabilisante, de préférence à base d'oxyde de zinc.

9. Matériau selon l'une quelconque des revendications précédentes **caractérisé en ce qu'**il comprend un empilement défini en partant du substrat transparent comprenant :
- un premier revêtement diélectrique comprenant au moins une couche diélectrique à fonction barrière et une couche diélectrique à fonction stabilisante,
- éventuellement une couche de blocage,
- une première couche fonctionnelle,
- éventuellement une couche de blocage,
- un deuxième revêtement diélectrique comprenant au moins une couche diélectrique à fonction stabilisante inférieure, une couche diélectrique à fonction barrière et une couche diélectrique à fonction stabilisante supérieure,
- éventuellement une couche de blocage,
- une deuxième couche fonctionnelle,
- éventuellement une couche de blocage,
- un troisième revêtement diélectrique comprenant au moins une couche diélectrique à fonction stabilisante inférieure, une couche diélectrique à fonction barrière et une couche diélectrique à fonction stabilisante supérieure,
- éventuellement une couche de blocage,
- une troisième couche fonctionnelle,
- éventuellement une couche de blocage,
- un quatrième revêtement diélectrique comprenant au moins une couche diélectrique à fonction stabilisante, une couche diélectrique à fonction barrière et éventuellement une couche de protection.

10. Matériau selon l'une quelconque des revendications précédentes, caractérisé en qu'il présente une réflexion lumineuse côté extérieur inférieure à 20 %.

11. Procédé d'obtention d'un matériau selon l'une des revendications précédentes, dans lequel on dépose les couches de l'empilement par pulvérisation cathodique magnétron.

12. Vitrage comprenant au moins un matériau selon l'une quelconque des revendications 1 à 11.

13. Vitrage selon la revendication précédente **caractérisé en ce que** l'empilement est positionné dans le vitrage de sorte que la lumière incidente provenant de l'extérieur traverse le premier revêtement diélectrique avant de traverser la première couche métallique fonctionnelle.

14. Vitrage selon l'une quelconque des revendications 12 ou 13, caractérisé en qu'il est sous forme de vitrage monolithique, feuilleté ou multiple, en particulier double vitrage ou triple vitrage.

## Patentansprüche

1. Material, umfassend ein transparentes Substrat, das mit einer Stapelung von Dünnschichten beschichtet ist, umfassend vom Substrat ausgehend nacheinander eine Abfolge von drei funktionellen Metallschichten auf Basis von Silber, die vom Substrat beginnend als erste, zweite und dritte funktionelle Schicht bezeichnet werden, und vier dielektrische Beschichtungen, die vom Substrat beginnend als M1, M2, M3 und M4 bezeichnet werden, wobei jede dielektrische Beschichtung mindestens eine dielektrische Schicht umfasst, sodass jede funktionelle Metallschicht zwischen zwei dielektrischen Beschichtungen angeordnet ist, **dadurch gekennzeichnet, dass:**
- das Material eine Lichtdurchlässigkeit geringer als 50 % vorweist,
- die Dicke der ersten funktionellen Schicht geringer als die Dicke der zweiten funktionellen Schicht ist,
- die Dicke der ersten funktionellen Schicht geringer als die Dicke der dritten funktionellen Schicht ist,
- das Verhältnis der Dicke der dritten funktionellen Metallschicht zur Dicke der zweiten funktionellen Schicht im Bereich zwischen 0,90 und 1,10 einschließlich dieser Werte liegt,
- die dielektrischen Beschichtungen M1, M2, M3 und M4 jeweils eine optische Dicke Eo1, Eo2, Eo3 und Eo4 aufweisen, die der folgenden Beziehung genügen: Eo4 < Eo1 < Eo2 < Eo3,
- die optische Dicke Eo1 der dielektrischen Beschichtung M1 im Bereich von 80 bis 140 nm liegt,
- die optische Dicke Eo2 der dielektrischen Beschichtung M2 im Bereich von 100 bis 170 nm liegt,
- die optische Dicke Eo3 der dielektrischen Beschichtung M3 im Bereich von 120 bis 240 nm liegt,
- die optische Dicke Eo4 der dielektrischen Beschichtung M4 im Bereich von 70 bis 120 nm liegt.

2. Material nach Anspruch 1, **dadurch gekennzeichnet, dass** die Dicke der zweiten funktionellen Schicht größer als 15 nm ist.

3. Material nach einem der vorstehenden Ansprüche, **dadurch gekennzeichnet, dass** die drei funktionellen Metallschichten den folgenden Eigenschaften genügen:
- die Dicke der ersten funktionellen Metallschicht liegt im Bereich zwischen 6 und 12 nm,
- die Dicke der zweiten funktionellen Metallschicht liegt im Bereich zwischen 15 und 20 nm,
- die Dicke der dritten funktionellen Metallschicht liegt im Bereich zwischen 15 und 20 nm.

4. Material nach einem der vorstehenden Ansprüche, **dadurch gekennzeichnet, dass** die Stapelung darüber hinaus mindestens eine Blockierschicht umfasst, die sich in Kontakt mit einer funktionellen Metallschicht befindet, ausgewählt aus den Metallschichten auf Basis eines Metalls oder einer Metalllegierung, Metallnitridschichten, Metalloxidschichten und Metalloxynitridschichten aus einem oder mehreren Elementen, ausgewählt aus Titan, Nickel, Chrom und Niob, wie eine Schicht aus Ti, TiN, TiOx, Nb, NbN, Ni, NiN, Cr, CrN, NiCr, NiCrN.

5. Material nach dem vorstehenden Anspruch, **dadurch gekennzeichnet, dass** die Gesamtdicke aller Blockierschichten, die mit den funktionellen Schichten in Kontakt stehen, im Bereich zwischen 4 und 7 nm einschließlich dieser Werte liegt.

6. Material nach einem der vorstehenden Ansprüche, **dadurch gekennzeichnet, dass** jede dielektrische Beschichtung mindestens eine dielektrische Schicht mit Barrierefunktion auf Basis von Silicium- und/oder Aluminiumverbindungen, ausgewählt aus den Oxiden wie SiO₂ und Al₂O₃, Siliciumnitriden Si₃N₄ und AlN und Oxynitriden SiOₓN_{y} und AlOₓN_{y}, beinhaltet.

7. Material nach einem der vorstehenden Ansprüche, **dadurch gekennzeichnet, dass jede** dielektrische Beschichtung mindestens eine dielektrische Schicht mit stabilisierender Funktion auf Basis von kristallisiertem Oxid, insbesondere auf Basis von Zinkoxid, gegebenenfalls mithilfe mindestens eines anderen Elements wie Aluminium dotiert, beinhaltet.

8. Material nach einem der vorstehenden Ansprüche, **dadurch gekennzeichnet, dass** jede funktionelle Schicht oberhalb einer dielektrischen Beschichtung, deren obere Schicht eine dielektrische Schicht mit stabilisierender Funktion, vorzugsweise auf Basis von Zinkoxid, ist, und/oder unterhalb einer dielektrischen Beschichtung liegt, deren untere Schicht eine dielektrische Schicht mit stabilisierender Funktion, vorzugsweise auf Basis von Zinkoxid, ist.

9. Material nach einem der vorstehenden Ansprüche, **dadurch gekennzeichnet, dass** es eine vom transparenten Substrat beginnende definierte Stapelung umfasst, umfassend:
- eine erste dielektrische Beschichtung, die mindestens eine dielektrische Schicht mit Barrierefunktion und eine dielektrische Schicht mit stabilisierender Funktion umfasst,
- gegebenenfalls eine Blockierschicht,
- eine erste funktionelle Schicht,
- gegebenenfalls eine Blockierschicht,
- eine zweite dielektrische Beschichtung, die mindestens eine untere dielektrische Schicht mit Stabilisierungsfunktion, eine dielektrische Schicht mit Barrierefunktion und eine obere dielektrische Schicht mit Stabilisierungsfunktion umfasst,
- gegebenenfalls eine Blockierschicht,
- eine zweite funktionelle Schicht,
- gegebenenfalls eine Blockierschicht,
- eine dritte dielektrische Beschichtung, die mindestens eine untere dielektrische Schicht mit Stabilisierungsfunktion, eine dielektrische Schicht mit Barrierefunktion und eine obere dielektrische Schicht mit Stabilisierungsfunktion umfasst,
- gegebenenfalls eine Blockierschicht,
- eine dritte funktionelle Schicht,
- gegebenenfalls eine Blockierschicht,
- eine vierte dielektrische Beschichtung, die mindestens eine dielektrische Schicht mit stabilisierender Funktion, eine dielektrische Schicht mit Barrierefunktion und gegebenenfalls eine Schutzschicht umfasst.

10. Material nach einem der vorstehenden Ansprüche, **dadurch gekennzeichnet, dass** es auf der Außenseite eine Lichtreflexion geringer als 20 % vorweist.

11. Verfahren zum Erhalten eines Materials nach einem der vorstehenden Ansprüche, wobei die Schichten der Stapelung durch Magnetron-Kathodenzerstäubung abgeschieden werden.

12. Verglasung, die mindestens ein Material nach einem der Ansprüche 1 bis 11 umfasst.

13. Verglasung nach dem vorstehenden Anspruch, **dadurch gekennzeichnet, dass** die Stapelung derart in der Verglasung positioniert ist, dass das von außen stammende einfallende Licht vor dem Durchqueren der ersten funktionellen Metallschicht die erste dielektrische Beschichtung durchquert.

14. Verglasung nach einem der Ansprüche 12 oder 13, **dadurch gekennzeichnet, dass** sie in Form von Einscheiben-, Verbund- oder Mehrfachverglasung, besonders Doppel- oder Dreifachverglasung, vorliegt.

## Claims

1. A material comprising a transparent substrate coated with a stack of thin layers successively comprising, starting from the substrate, an alternation of three silver-based functional metallic layers referred to, starting from the substrate, as first, second and third functional layers and of four dielectric coatings, referred to, starting from the substrate, as M1, M2, M3 and M4, each dielectric coating comprising at least one dielectric layer, so that each functional metallic layer is positioned between two dielectric coatings, **characterized in that**:
- the material provides a luminous transmission lower than 50%,
- the thickness of the first functional layer is less than the thickness of the second functional layer,
- the thickness of the first functional layer is less than the thickness of the third functional layer,
- the ratio of the thickness of the third functional metallic layer to the thickness of the second functional layer is between 0.90 and 1.10, including these values,
- the dielectric coatings M1, M2, M3 and M4 each have an optical thickness Eo1, Eo2, Eo3 and Eo4 satisfying the following equation: Eo4 < Eo1 < Eo2 < Eo3,
- the optical thickness Eo1 of the dielectric coating M1 is comprised from 80 to 140 nm,
- the optical thickness Eo2 of the dielectric coating M2 is comprised from 100 to 170 nm,
- the optical thickness Eo3 of the dielectric coating M3 is comprised from 120 to 240nm,
- the optical thickness Eo4 of the dielectric coating M4 is comprised from70 to 120 nm.

2. The material as claimed in claim 1, **characterized in that** the thickness of the second functional layer is greater than 15 nm.

3. The material as claimed in either of the preceding claims, **characterized in that** the three functional metallic layers satisfy the following characteristics:
- the thickness of the first functional metallic layer is between 6 and 12 nm,
- the thickness of the second functional metallic layer is between 15 and 20 nm,
- the thickness of the third functional metallic layer is between 15 and 20 nm.

4. The material as claimed in any one of the preceding claims, **characterized in that** the stack also comprises at least one blocking layer located in contact with a functional metallic layer selected from metallic layers based on a metal or on a metal alloy, metal nitride layers, metal oxide layers and metal oxynitride layers of one or more elements selected from titanium, nickel, chromium and niobium, such as a Ti, TiN, TiOx, Nb, NbN, Ni, NiN, Cr, CrN, NiCr or NiCrN layer.

5. The material as claimed in the preceding claim, **characterized in that** the total thickness of all the blocking layers in contact with the functional layers is between 4 and 7 nm, including these values.

6. The material as claimed in any one of the preceding claims, **characterized in that** each dielectric coating comprises at least one dielectric layer having a barrier function based on silicon and/or aluminum compounds selected from oxides such as SiO₂ and Al₂O₃, silicon nitrides Si₃N₄ and AlN and oxynitrides SiOₓN_{y} and AlOₓN_{y}.

7. The material as claimed in any one of the preceding claims, **characterized in that** each dielectric coating comprises at least one dielectric layer having a stabilizing function based on a crystalline oxide, in particular based on zinc oxide, optionally doped with the aid of at least one other element, such as aluminum.

8. The material as claimed in any one of the preceding claims, **characterized in that** each functional layer is on top of a dielectric coating, the upper layer of which is a dielectric layer having a stabilizing function, preferably based on zinc oxide and/or underneath a dielectric coating, the lower layer of which is a dielectric layer having a stabilizing function, preferably based on zinc oxide.

9. The material as claimed in any one of the preceding claims, **characterized in that** it comprises a stack, defined starting from the transparent substrate, comprising:
- a first dielectric coating comprising at least one dielectric layer having a barrier function and one dielectric layer having a stabilizing function,
- optionally a blocking layer,
- a first functional layer,
- optionally a blocking layer,
- a second dielectric coating comprising at least one lower dielectric layer having a stabilizing function, one dielectric layer having a barrier function and one upper dielectric layer having a stabilizing function,
- optionally a blocking layer,
- a second functional layer,
- optionally a blocking layer,
- a third dielectric coating comprising at least one lower dielectric layer having a stabilizing function, one dielectric layer having a barrier function and one upper dielectric layer having a stabilizing function,
- optionally a blocking layer,
- a third functional layer,
- optionally a blocking layer,
- a fourth dielectric coating comprising at least one dielectric layer having a stabilizing function, one dielectric layer having a barrier function and optionally one protective layer.

10. The material as claimed in any one of the preceding claims, **characterized in that** it has a light reflection on the external side of less than 20%.

11. A process for obtaining a material as claimed in one of the preceding claims, wherein the layers of the stack are deposited by magnetron sputtering.

12. A glazing comprising at least one material as claimed in any one of claims 1 to 11.

13. The glazing as claimed in the preceding claim, **characterized in that** the stack is positioned in the glazing so that the incident light coming from outside passes through the first dielectric coating before passing through the first functional metallic layer.

14. The glazing as claimed in either one of claims 12 or 13, **characterized in that** it is in the form of monolithic, laminated or multiple glazing, in particular double glazing or triple glazing.
